# EUROPÄISCHE PATENTSCHRIFT

(11) **EP 2 987 185 B1**
(45) Veröffentlichungstag und Bekanntmachung des Hinweises auf die Patenterteilung: **08.01.2020**
(21) Anmeldenummer: 14715286.2
(22) Anmeldetag: 03.04.2014
(51) Int. Cl.: H01L 31/048, H01L 31/052

(54) **FASSADEN- ODER DACHELEMENT**
FAÇADE ELEMENT OR ROOF ELEMENT
PANNEAU DE FAÇADOU DE TOITURE

(30) Priorität: 18.04.2013 CH 792132013
(43) Veröffentlichungstag der Anmeldung: 24.02.2016
(73) Patentinhaber: Bs2 AG, 8952 Schlieren (CH)
(72) Erfinder: BAETSCHMANN, Marc, 8057 Zürich (CH)
(74) Vertreter: Troesch Scheidegger Werner AG
(86) Internationale Anmeldenummer: PCT/EP2014/056731
(87) Internationale Veröffentlichungsnummer: WO 2014/170137

(56) Entgegenhaltungen:
- WO-A1-2013/046195
- DE-A1-102004 041 533
- DE-A1-102009 048 086
- DE-A1-102011 101 212
- DE-U1- 20 014 536
- GB-A- 2 463 671
- JP-A- H1 062 017
- JP-A- 2002 139 252
- US-A- 4 392 008
- US-A1- 2012 262 040

## Beschreibung

Die vorliegende Erfindung betrifft ein Fassaden- oder Dachelement gemäss dem Oberbegriff nach Anspruch 1, sowie eine Dach- oder Fassadenkonstruktion mit mindestens einem Fassaden- oder Dachelement.

Solarstrahlung ist eine Energieform, die mehrheitlich im rel. kurzwelligen Frequenzbereich von weniger als 2 Mikrometer Wellenlänge auf der Erdoberfläche auftritt. Die Energie der Solarstrahlung kann teilweise in elektrischen Strom oder auch teilweise in Wärmeenergie umgewandelt werden. In beiden Prozessen der Energieumwandlung wird die Energie der Photonen der Solarstrahlung teilweise durch einen festen Körper absorbiert. In der photovoltaischen Zelle wird ein möglichst hoher Energieanteil der Photonen direkt in einen elektrischen Energiestrom umgewandelt.

Der Anteil absorbierter Strahlungsenergie kann nicht zu 100% in elektrische Energie umgewandelt werden. Der Rest wird in thermische Energie gewandelt, die aus der photovoltaischen Zelle abgeführt werden muss, um deren Leistungsfähigkeit zu erhalten. Da der photovoltaische Effekt von der Temperatur der absorbierenden Schicht abhängt (höhere Temperaturen vermindern den elektrischen Wirkungsgrad), muss die Wärme bei relativ tiefer Temperatur aus der photovoltaischen Zelle abgeführt werden.

Die photovoltaische Schicht ist sehr dünn und muss aus Festigkeitsgründen mechanisch an bzw. auf einer Tragplatte fixiert werden, die die verschiedenen Kräfte auf die Fläche aufnimmt und an eine Tragstruktur überträgt, die ihrerseits fest mit der Erde verbunden ist. Das Element bestehend aus der photovoltaischen Schicht und der kraftübertragenden Tragplatte wird als Solarpaneel bezeichnet.

Ein Trend der Photovoltaik ist die Gebäudeintegration, die Funktionsvereinigung der Gebäudehülle und den stromerzeugenden Photovoltaikmodulen. Dabei ersetzt das Photovoltaikmodul die äusserste Gebäudeschicht, z.B. den Ziegel. Das Photovoltaikmodul wird mit einem Befestigungssystem, z.B. Haken, direkt auf der Dachunterkonstruktion befestigt.

In der heutigen Gebäudeintegration wird der sinkenden Effizienz von höheren Modultemperaturen mittels natürlicher oder erzwungener Hinterlüftung der Module entgegengewirkt. Im Dachaufbau werden Konstruktionen mit einem Abstand zwischen Modul und Dämmung eingesetzt, die so eine Kühlung mittels natürlicher Konvektion erlaubt. Eine zuverlässige Kühlung wird nicht in allen Fällen zufriedenstellend erreicht. So ist in gebäudeintegrierten Anlagen neben der stärkeren Beanspruchung des Moduls oft ein elektrischer Minderertrag festzustellen. Eine aktive Kühlung wird bei reiner Photovoltaik kaum eingesetzt. Es existieren sogenannte "Hybridsysteme" mit aktiver Luftkühlung der Modulrückseite mittels erzwungener Konvektion über die gesamte Dachfläche. Oder neuerdings bekannte Hybridkollektoren, deren Kühlung auf einzelne Module beschränkt ist.

Bestehende bzw. bekannte Systeme zur Verwertung der aus photovoltaischen Zellen abzuführender Wärme sind meistens darauf ausgerichtet, die Wärme bei möglichst hohen Temperaturen und möglichst grossflächig auf der absorbierenden Schicht auszukoppeln. Dadurch ergeben sich aufwendige Paneel-Konstruktionen. Derartige Systeme sind beispielsweise bekannt aus der WO 2009/149572, der DE 20 2007 010 901, der DE 20 2007 000529, der EP 1 914 489 sowie der DE 20 2007 009 162. Weiter beschreibt die JP 10062017 ein photovoltaisches stromerzeugendes und wärmeerzeugendes Hybridpanel verwendet als Abdeckmodul, wobei der hinter der photovoltaischen Zelle angeordnete Wärmekollektor an der Modulrückseite eine Luftkühlung aufweist. Ähnliche Module werden in der WO 2012/155850 und der WO 2011/014120 beschrieben, wobei auch hier an der Modulrückseite jeweils eine Luftkühlung vorgesehen ist.

Ferner wird auf JP H1062017 A, DE 10 2009 048086 A1, GB 2 463 671 A1 und DE 10 2011 101212 A1 verwiesen. Bei diesen bekannten Lehren handelt es sich jeweils um ein einzelnes Solarzellenmodul, das als Ganzes beispielsweise auf dem Dach eines Hauses verbaut wird.

Die Aufgabe der vorliegenden Erfindung besteht darin, einerseits die in photovoltaischen Solarzellen anfallende Wärme weitgehendst abführen und nutzen zu können und andererseits sogenannte Hybridsolarmodule zu schaffen, welche mit möglichst geringem konstruktivem Aufwand in Gebäudekonstruktionen wie Dächer und Fassade integrierbar sind.

Erfindungsgemäss wird ein Fassaden- oder Dachelement gemäss dem Wortlaut nach Anspruch 1 vorgeschlagen.

Die erfindungsgemässe Idee besteht in einer Funktionsvereinigung von Gebäudehülle, Photovoltaik, thermischem Absorber und neuerdings der Gebäudewärmedämmung, also um ein komplettes Dach- oder Fassadenelement mit integrierter Gewinnung von sowohl elektrischer als auch thermischer Energie und gleichzeitiger Isolation der Gebäudehülle.

Erfindungsgemäss vorgeschlagen wird, dass das Fassaden- oder Dachelement nebst mehrerer photovoltaischer Solarzellen mindestens eine wärmeleitend mit der oder den Solarzellen verbundene wärmeleitende Schicht wie eine Wärmeübertragungsplatte aufweist, welche vorzugsweise weitgehendst flächig mit dem Solarpanel verbunden ist. An der, der Solarzelle gegenüberliegenden Oberfläche der wärmeleitenden Schicht ist eine Wärmedämmung angeordnet, womit die Gebäudeisolation entgegen den üblicherweise bekannten sogenannten Hybridkollektoren integral im Fassaden- oder Dachelement mit eingeschlossen ist.

Weiter vorgeschlagen wird, dass in oder an der oder den Wärmeleitschichten Mittel zum Zu- oder Ableiten von Wärme in oder aus der Wärmeleitschicht vorgesehen sind wie beispielsweise ein Wärmeträgermedium, welches in einer Wärmetransportrohranordnung geführt wird.

Wiederum gemäss einer weiteren Ausführungsvariante wird vorgeschlagen, dass die Wärmeleitschicht, wie die Wärmeübertragungsplatte gleichzeitig als Tragplatte die photovoltaische Schicht aus Festigkeitsgründen mechanisch fixiert, wobei beispielsweise mehrere segmentartige Wärmeleitschichten vorgesehen sein können, welche gegebenenfalls voneinander beabstandet sind.

Wiederum gemäss einer Ausführungsvariante ist vorgesehen, dass in der Wärmedämmung bzw. in der Dämmschicht Nuten oder Rillen an der Wärmeleitschicht zugewandten Oberfläche vorgesehen sein können, zum Entwässern, Entfeuchten und/oder Entlüften des Dach- oder Fassadenelementes, oder dass mindestens teilweise die Dämmschicht und die Wärmeleitschicht zu diesem Zweck zur Bildung von Zwischenräumen voneinander beabstandet sind.

Wiederum gemäss einer weiteren Ausführungsvariante ist vorgesehen, dass die Wärmeleitschicht selbst oder die, die Wärmeleitschicht bildenden Segmenten, wie bspw. Lamellen, je mindestens eine Abstufung aufweisen. Dadurch wird es möglich, dass bei Verwendung mehrerer Solarzellen pro Element entlang einer Verbindungskante zweier benachbarter Solarzellen diese sich im Bereich der Abstufung teilweise überlappend angeordnet werden können entsprechend dem Anordnen von Abdeckplatten in einer Dachkonstruktion.

Wird nun die zusätzlich auf die Gebäudeintegration der Photovoltaik um eine Funktionsintegration mit der Dämmung erweitert, ist eine kontrollierte Kühlung der Photovoltaikzellen vorteilhaft. Mittels eines beispielsweisen flüssigkeitsdurchströmten Absorbers, der auf der Solarzellen-Rückseite angebracht wird, kann die Wärme jederzeit in großer Menge abgeführt werden. Dies erhöht die Langlebigkeit der Module sowie den elektrischen Wirkungsgrad. Der elektrische Mehrertrag eines mittels thermischem Absorbers gekühlten und hinterlüfteten PV-Moduls beträgt im Vergleich zu einem nicht gekühlten, hinterlüfteten PV-Moduls ca. 4 bis 5%. Beim Vergleich eines nicht hinterlüfteten, gekühlten PV-Moduls mit einem ebenfalls nicht hinterlüfteten und ungekühlten PV-Moduls steigt der Unterschied auf bis zu 10%.

Die zusätzliche erfindungsgemäss integrierte Gebäudedämmung wirkt gleichzeitig als thermische Dämmung auf der Rückseite des Hybridkollektors. Damit wird im Vergleich zu nicht gedämmten Kollektoren ein thermischer Mehrertrag von jährlich 12-15% erreicht. Wird die Dämmung des Kollektors mit der Gebäudehüllendämmung kombiniert, kann dieser Mehrertrag ohne zusätzlichen Material- und grauen Energieeinsatz erreicht werden.

Neu erfolgt die Hybridisierung nicht mehr einzeln pro Modul sondern führt über mehrere Module bzw. Solarzellen. Die fluidführende Wärmeleitplatte beispielsweise aus Aluminium ist Teil des Gesamtelements und wird gleichzeitig als statische Struktur eingesetzt. Sie dient einerseits als statisches Tragelement der Photovoltaiksolarzellen und andererseits wirkt sie als Befestigungssystem der Photovoltaikmodule auf dem Dach. Die Hybridisierung vereint den thermischen Absorber mit der Unterkonstruktion und bildet eine kühlbare Dachstruktur. Das beispielsweise Aluminiumdach kann bereits eine komplett wasserdichte Konstruktion bilden.

Die hydraulischen Anschlüsse können am Elementrand angeordnet sein und können miteinander sowohl seriell als auch parallel verschaltet werden. Im Vergleich zu den hybridisierten bekannten Einzelmodulen sind diese Anschlüsse leicht zugänglich und z.B. visuell überprüfbar. Der Absorber ist konstruktiv so ausgebildet, dass er eine Anordnung der Photovoltaikmodule infolge der wiederentfernbaren Befestigung erlaubt, damit diese die Funktion der wasserabweisenden Gebäudehülle erfüllen können. Zudem ist es möglich, jedes Photovoltaikmodul einzeln aus der Konstruktion zu entfernen und z.B. bei Defekt zu ersetzen. Dazu wird der hydraulische Kreislauf nicht unterbrochen und somit muss das System für den Modulaustausch nicht entleert, neu befüllt und entlüftet werden. Es ist lediglich der elektrische Kreis zu unterbrechen und das Modul zu ersetzen.

Die Unterkonstruktion kann auch mit anderem Abdeckmaterial als elektrisch aktiven Photovoltaikmodulen belegt werden. Z.B. Dummymodule (elektrisch nicht funktionsfähig), Glasplatten, Eternitplatten, etc.

Die funktionsgemässe Funktionsvereinigung der Energieerzeugung mit der Gebäudehülle (wasserführende Schicht, Brandschutz, etc.) ermöglicht eine Reduktion der Anzahl Schichten eines Dachaufbaus.

Vertikale Wasserablaufrinnen können in das Trägerprofil integriert werden oder als separates Element zwischen den Modulen verlegt werden. Aufgrund der Längendilatation der Module können diese überlappend, resp. mit einem Abstand verlegt werden.

Die statischen Anforderungen des Photovoltaikmoduls werden zusätzlich von der Unterkonstruktion übernommen, dies erlaubt die Photovoltaikmodule selber mit einer geringeren Eigenstabilität zu bauen, was zu Materialeinsparungen und folglich Kostensenkung der Photovoltaikmodulen führt.

Das System kann sowohl für Dächer wie auch für Fassaden eingesetzt werden.

Das Gesamtelement ist so ausgeführt, dass es leicht vorfabriziert werden kann und als gesamtes Dachelement auf die Baustelle transportiert und dort versetzt werden kann. Eine mögliche beispielsweise Vorfabrikation von solchen grossflächigen Dachelementen vereinfacht zusätzlich sowohl den Planungs- als auch den Installationsprozesses. Das Element und dessen Verbindungen können bereits in der Produktionshalle geprüft werden. Neben der kleineren Anzahl von Verbindungen und dem dementsprechend kleineren statistischen Risikos eines Defekts wird somit ein grosser Teil der Qualitätssicherung von der Baustelle in die Produktionshalle verlagert.

Es ist natürlich auch möglich, die Photovoltaikmodule erst auf der Baustelle auf die vorfabrizierte Unterkonstruktion zu versetzen.

Entscheidende Vorteile des neuartigen System-Bauelements sind demnach Kosten- und Materialeinsparungen sowohl des Dachs wie auch der einzelnen Komponenten. Sowie ein einfacherer, schnellerer und sicherer Planungs- und Installationsprozess. Somit wird eine Reduktion der Gesamtanlagenkosten erreicht. Diese Konstruktion führt zu einer neuen Dacharchitektur, somit ist neben den technischen und ökonomischen Vorteilen ist die Gebäudeintegration von Hybridkollektoren aus baurechtlichen Gründen erstrebenswert.

Ein weiterer Vorteil eines solchen Dachelementes ist ein geringerer Wärmeeintrag übers Dach ins Gebäude bei hoher Sonneneinstrahlung. Dies erhöht den Komfort, insbesondere in ausgebauten Dachgeschossen, da die Wärme kontrolliert aus dem Dachelement abgeführt werden kann.Die Erfindung wird nun beispielsweise und unter Bezug auf die beigefügten Figuren näher erläutert.

Dabei zeigen:
Fig. 1 in perspektivischer Draufsicht eine fluidgekühlte lamellenartige Trägerkonstruktion zusammen mit der dahinter angeordneten Wärmedämmung,
Fig. 2a und 2b einzelne Lamellen der Trägerschicht zum Halten der Solarzellen in Perspektive,
Fig. 3 in perspektivischer Draufsicht ein erfindungsgemässes Dachelement unter Verwendung der Trägerlamellen und der Dämmschicht aus Fig. 1,
Fig. 4 einen Querschnitt durch eine Dachkonstruktion unter Verwendung von erfindungsgemässen Dachelementen,
Fig. 5 im Querschnitt eine Solarzelle befestigt auf einer Lamelle der wärmeleitenden Trägerschicht und
Fig. 6 schematisch das Zusammenfügen und Anordnen der verschiedenen Module und Schichten zu einem erfindungsgemässen Dachelement
Fig. 7 unterschiedliche Ausprägungen der Rillen und Nuten in der Dämmschicht zur Gestaltung eines Zwischenraums
Fig. 8a-c unterschiedliche Gestaltungsarten der Zwischenräume zwischen Dämmschicht und Trägerlamelle
Fig. 9 das Anordnen mehrerer Dachelemente auf einem Hausdach.

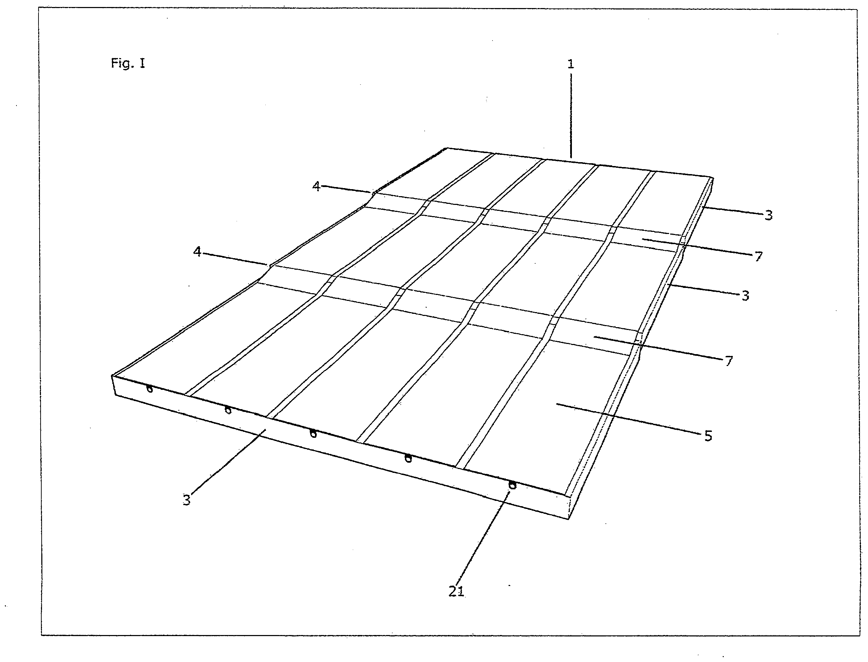

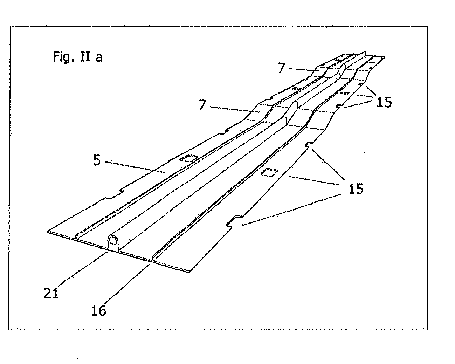

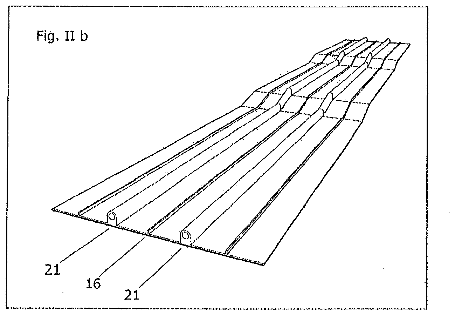

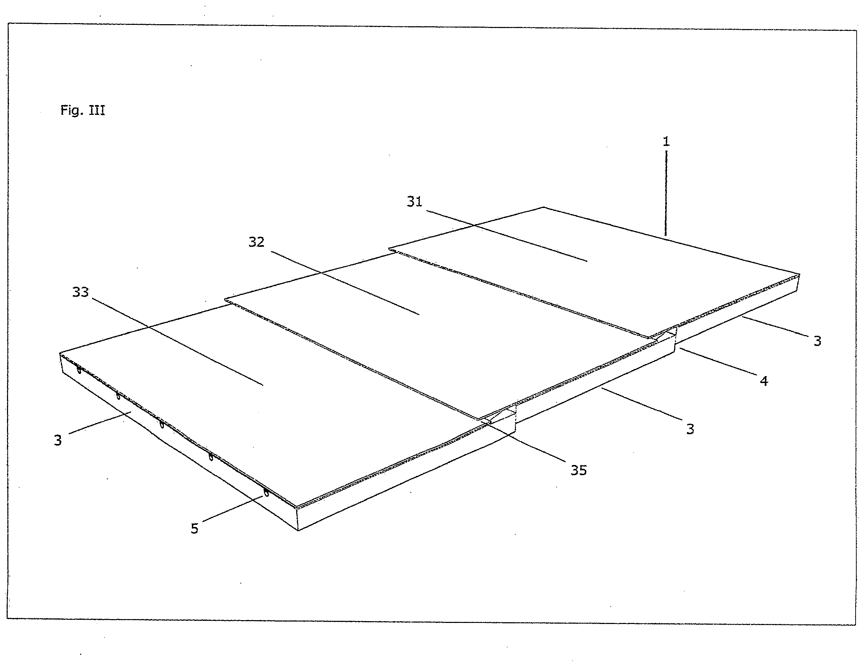

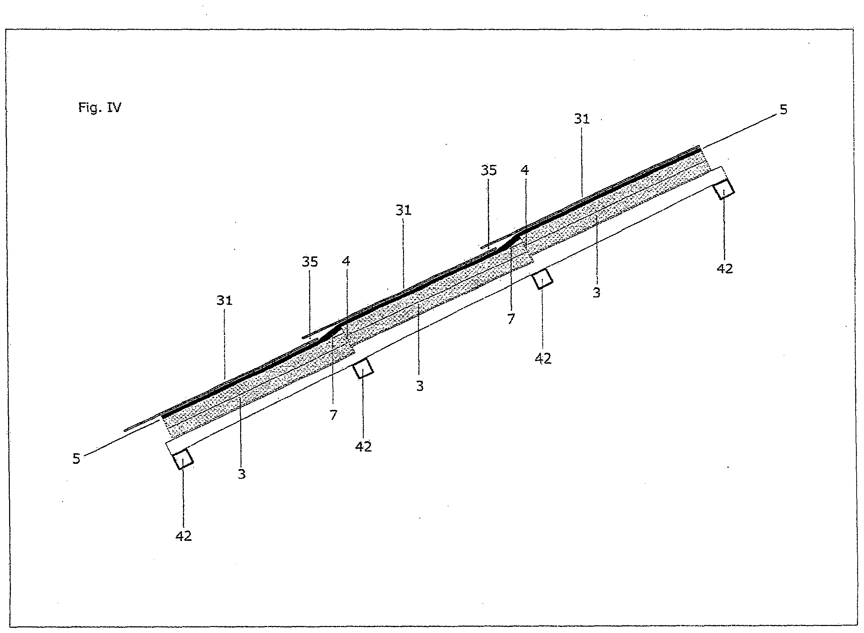

Fig. 1 zeigt in perspektivischer Draufsicht den Aufbau eines erfindungsgemässen Dachpanels 1 ohne die darauf anzuordnende Solarzelle. Auf einer Dämmschicht 3 beispielsweise bestehend aus einem Wärmeisolationsmaterial der bekannten Art sind gut wärmeleitende beispielsweise lamellenartige Metallprofile 5 vorgesehen, beispielsweise bestehend aus Aluminium. Selbstverständlich ist es möglich, die Wärmeleitschicht oder Tragschicht für die Solarzellen einstückig auszubilden oder die einzelnen Segmente andersartig auszubilden, wie trapezförmig, dreiecks-förmig, Rhombus artig, etc. Doch scheint das lamellenartige Ausbilden sowohl fertigungstechnisch vorteilhaft zu sein, wie ergeben sich dadurch auch mechanische wie thermische Vorteile. Gut erkennbar ist in den dargestellten Lamellen 5 eine Abstufung 7, auf deren Funktionsweise später, insbesondere unter Bezug auf die beiden Figuren 3 und 4 eingegangen wird. Entsprechend der Abstufungen 7 ist auch eine Stufe 4 in der darunter angeordneten Dämmschicht 3 vorgesehen. Wärmeleitend mit den Metalllamellen 5 sind Rohre 21 vorgesehen, welche integral mit den Wärmeleitplatten verbunden sind zum Führen eines fluiden Wärmetransportmediums. Selbstverständlich können die einzelnen Lamellen auch in zur Darstellung um 90% gedrehter Position angeordnet werden, womit auch die Abstufung eine andere Lage erhält.

Fig. 2a zeigt in perspektivischer Ansicht eine einzelne Metall- bzw. Traglamelle 5 von unten gesehen, mit dem integral damit verbundenen Leitungsrohr 21. Ebenfalls gut erkennbar ist die Abstufung 7. Eine derartige Metalllamelle, beispielsweise bestehend aus Aluminium kann mittels Strangextrusion erzeugt werden. Anstelle von Metall kann selbstverständlich auch ein wärmeleitendes, bspw. gefülltes Polymer verwendet werden.

Schliesslich erkennbar sind Lochungen 15 in den Metalllamellen 5, vorgesehen für das einsteckbare Halten von Solarzellen.

Fig. 2b zeigt eine weitere mögliche Ausführung der Metall- bzw. Traglamelle 5 mit integriertem Abstandhalter 16.

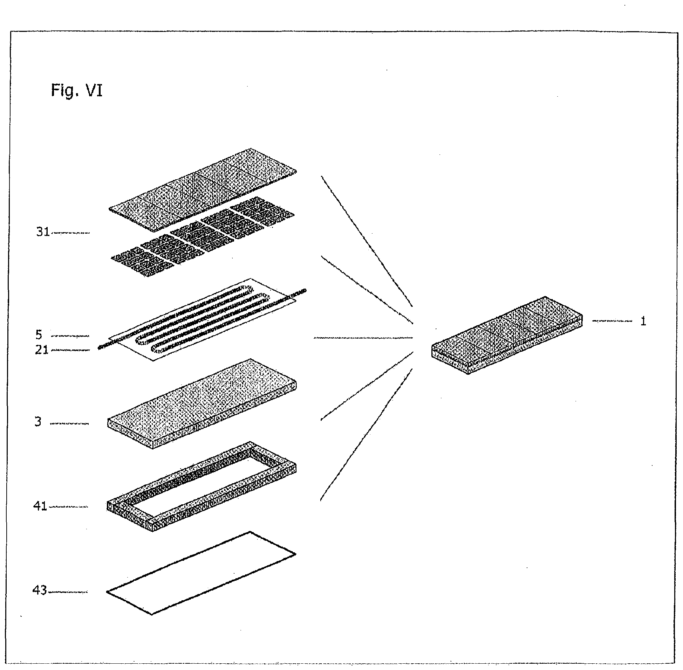

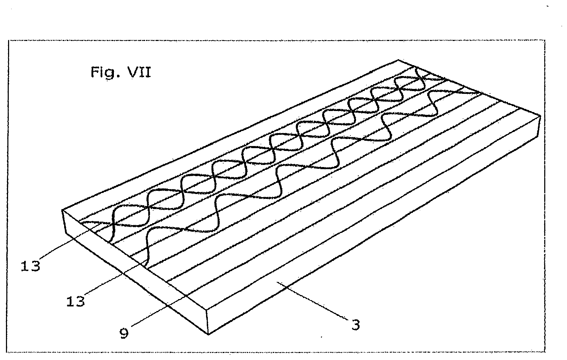

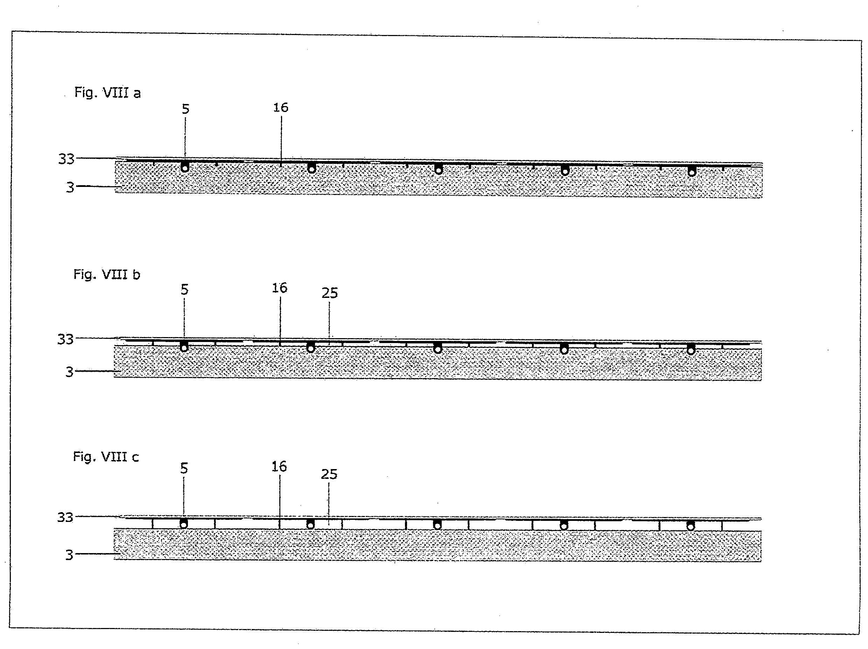

In Fig. 3 ist analog der Ansicht von Fig. 1 wiederum ein erfindungsgemässes Dachelement 1 in perspektivischer Draufsicht dargestellt. Zusätzlich zu den Elementen dargestellt in Fig. 1 sind in Fig. 3 drei Solarzellen 31, 32 und 33 angeordnet, welche fest mit den wärmeleitenden Trägerprofilen bzw. Trägerlamellen 5 verbunden sind. Im Bereich der Abstufung 7 der Träger- oder Metalllamellen 5 bzw. der Stufe 4 der Dämmung 3 überlappen sich die Solarzellen 31 und 37 beispielsweise um eine Distanz 35. Diese Überlappung der Solarzellen im Dachelement 1 entspricht dem Überlappen von Dachabdeckplatten wie beispielsweise Ziegeln, Eternitplatten, etc. um ein Abfliessen beispielsweise von Regenwasser sicher zu stellen. Um allfällig im Überlappungsbereich trotzdem in das darunter liegende Element eindringendes Regenwasser abführen zu können sind in der Dämmschicht 3 vorgesehene Längsrillen verantwortlich. Statt der Rillen ist es auch möglich, dass durch die bspw. von der Wärmeleitplatte nach unten vorstehenden Leitungsrohre, Zwischenräume 41 zwischen Wärmeleitschicht und Dämmschicht entstehen, durch welche ein Abfliessen des Wassers oder eine Entlüftung sichergestellt wird. Dies wird beispielshaft in den Fig. 8 a-c dargestellt. Durch die relativ grosse Fläche von Solarzellen ist es nun aber auch wichtig, dass diese fest mit den darunter liegenden wärmeleitenden Trägerlamellen 5 verbunden sind, um beispielsweise bei extremen Windverhältnissen den auftretenden Kräften entgegenwirken zu können. Einerseits ist es möglich mittels beispielsweise Haken die Solarzellen in den Lochungen 15 in den lamellenartigen Metallträgerplatten festzuhalten. Andere Befestigungssysteme zum sicheren Halten von Solarzellen auf Trägerplatten sind beispielsweise aus der WO 2011/076456 bekannt, Fig. 4 zeigt im Querschnitt eine Dachkonstruktion mit einem erfindungsgemässen Dachelement, aufweisend mehrere Solarzellen 31, welche jeweils am oberen und am unteren Rand sich überlappend auf der darunter angeordneten Trägerschicht 5 befestigt sind. Die dargestellte Trägerschicht bzw. Wärmeleitlamelle 5 weist im dargestellten Ausführungsbeispiel zwei Abstufungen 7 auf, und auch in der darunter liegenden Wärmedämmschicht 3 sind entsprechende Stufen 4 ausgebildet. Schliesslich integral mit der Trägerlamelle 5 verbunden ist ein Rohr 21 für das Führen des Wärmeträgermediums.

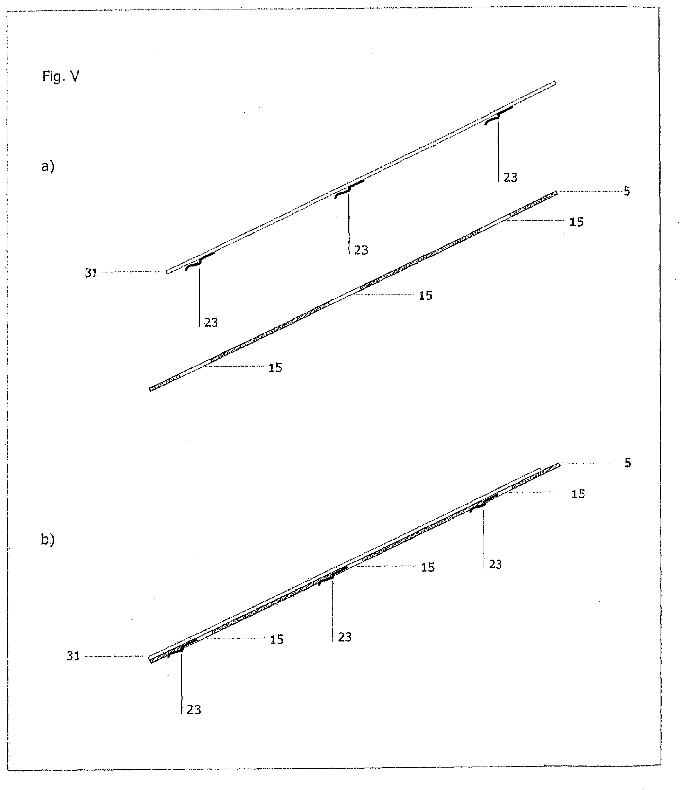

Fig. 5 zeigt eine mögliche Befestigung der Solarzelle 31 auf der Wärmeleitschicht bzw. Trägerlamelle 5, im Bereich der Öffnungen 15. Durch beispielsweise klammerartig federnde Haken 21, welche an der Solarzelle 31 befestigt sind, sind diese, die Lamelle im Bereich der Öffnung 15 hintergreifend fest angeordnet. Durch Schieben in Pfeilrichtung A kann die einzelne Solarzelle 31 entfernt werden, wodurch auch ein einzelnes Auswechseln einer Solarzelle in einem Dach- oder Fassadenelement ermöglicht wird. Selbstverständlich sind andere Befestigungssysteme möglich.

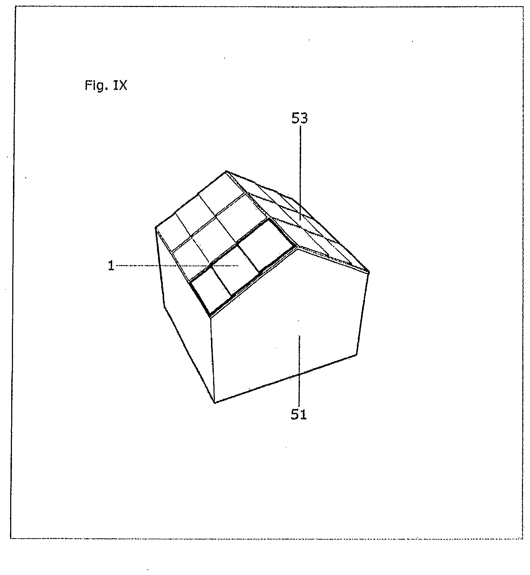

Anhand von Fig. 6 schliesslich soll schematisch dargestellt werden, wie ein erfindungsgemässes Dachelement aufgebaut wird um anschliessend auf einem Dach 53 eines Gebäudes 51 angeordnet zu werden, was in Fig. 9 gezeigt wird. Die Solarzelle 31, bestehend aus Glasüberdeckung und photovoltaischer Elektrostruktur ist auf einer beispielsweisen metallenen Trägerplatte 5 angeordnet, enthalten eine Rohranordnung 21 für das Führen des Wärmeträgermediums. Die Wärmeleitplatte 5 ihrerseits wird auf einer Wärmedämmung 3 angeordnet und fest mit dieser verbunden. Schliesslich ist eine üblicherweise in Dachkonstruktionen vorgesehene beispielsweise Holzkonstruktion 41 vorgesehen mit beispielsweise rauminnenseitiger Holzabdeckung 43. Das so gestaltete Element 1 kann vorgefertigt auf einem im Bau stehenden Gebäude 51 angeordnet werden. Selbstverständlich können auf einem Dach je nach Grösse auch in Dachneigungsrichtung mehrere Dachelemente angeordnet werden. Die Grösse und Form des Dachelementes ist einerseits abhängig von der Dachkonstruktion, der Transportfähigkeit der Elemente, etc., oder der Grösse oder Geometrie des abzudeckenden Daches. So können die Elemente auch Trapez-, Dreieck- oder Rhombus förmig, etc. sein.

In Fig. 7 sind in der Dämmschicht 3 einerseits beispielsweise in Lamellenrichtung verlaufende Rillen oder Nuten 9, sowie eine Rillenstruktur 13, welche beispielsweise sinuskurvenförmig ausgebildet sein kann, erkennbar. Diese Nuten und Rillen sind insbesondere dazu vorgesehen, um beispielsweise durch die Dachkonstruktion eindringendes Regenwasser, im Dachelement auftretende Feuchtigkeit abzuführen oder generell um das Dachelement zu entlüften. Insbesondere die zwischen den Metalllamellen geführten Rillen 9 sind zur Entwässerung vorgesehen.

In Fig. 8a-c sind beispielhaft unterschiedliche Ausprägungen des Zwischenraums 41 dargestellt.

Fig. 8a zeigt die vollständige Integration des Absorbers in die Dämmschicht.

Fig. 8b zeigt eine teilweise Integration der Lamelle in die Dämmschicht mit der Ausbildung des Zwischenraums 41 durch einen Distanzhalter, der in diesem Fall in die Lamelle formintegriert ist.

Fig. 8c zeigt die Ausbildung der Zwischenräume mit dem Abstand, der sich durch die Auflage der Lamelle auf die flächige Dämmschicht ergibt.

Analog zur dargestellten Dachkonstruktion ist es selbstverständlich auch möglich analoge Fassadenelemente zu erzeugen und diese an einer Hausfassade anzuordnen.

Bei den in den Figuren 1 bis 9 dargestellten Dachelementen handelt es sich selbstverständlich nur um Beispiele zur besseren Erläuterung der vorliegenden Erfindung. So ist es möglich pro Dachelement eine oder mehrere Solarzellen anzuordnen, die darunter angeordnete wärmeleitende Trägerschicht einstückig oder mittels mehrerer Lamellen auszubilden und auch in den einzelnen Lamellen können eine oder mehrere Abstufungen vorgesehen werden. Auch die darunter liegende Dämmung kann unterschiedlich ausgebildet sein, und auch muss diese nicht zwingend fest an der wärmeleitenden Trägerschicht anliegend ausgebildet sein. Das für die Wärmedämmung verwendete Material ist nicht Teil der vorliegenden Erfindung und die unterschiedlichsten Materialien können hierzu verwendet werden. Vorteilhaft ist, dass im erfindungsgemässen vorgeschlagenen Dachelement weitere Funktionselemente integriert werden können, wie Brandschutz, Schallschutz, etc.

Erfindupgswesentlich ist, dass im erfindungsgemäss vorgeschlagenen Dach- bzw. Fassadenelement das photovoltaische Solarmodul bzw. die Zellen, die wärmeleitend damit verbundene Trägerschicht und neuerdings die Wärmedämmung angeordnet an der zum Solarmodul entgegengesetzten Oberfläche, zu einem einzigen Element zusammengefügt sind.

## Patentansprüche

1. Fassaden- oder Dachelement, aufweisend mehrere photovoltaische Solarzellen bzw. Module, wobei eine wärmeleitende Schicht (5) mit den Solarzellen (31, 32, 33) bzw. Modulen verbunden ist sowie mindestens eine Wärmedämmung (3), die an der der Solarzellen bzw. Modulen entgegengesetzten Oberfläche der wärmeleitenden Schicht (5) angeordnet ist, wobei die wärmeleitende Schicht (5) durch mehrere Segmente gebildet wird und mehrere Solarzellen bzw. Module aufnimmt, wobei, dass in der wärmeleitenden Schicht (5) oder den Segmenten der wärmeleitenden Schicht (5) eine oder mehrere Abstufungen (7) vorgesehen sind, dass die Überlappung der Solarzellen bzw. Module im Bereich der Abstufungen der wärmeleitenden Schicht (5) oder der Segmente vorgesehen ist, um ein Abfliessen von Regenwasser sicher zu stellen, und dass in oder an der oder den wärmeleitenden Schichten (5) Mittel (21) zum Zu- oder Ableiten von Wärme in oder aus der wärmeleitenden Schicht (5) angeordnet sind.

2. Fassaden- oder Dachelement nach Anspruch 1, **dadurch gekennzeichnet, dass** die Wärmedämmung (3) Rillen oder Nuten (9) aufweist und/oder zwischen wärmeleitender Schicht (5) und der Wärmedämmung (3) Zwischenräume vorgesehen sind zum Entwässern, Entfeuchten und/oder Entlüften des Elementes.

3. Fassaden- oder Dachelement nach einem der Ansprüche 1 bis 2, **dadurch gekennzeichnet, dass** die Solarzelle bzw. das Modul wieder lösbar mit der wärmeleitenden Schicht (5) verbunden ist.

4. Fassaden- oder Dachelement nach einem der Ansprüche 1 bis 3, **dadurch gekennzeichnet, dass** mindestens ein Teil der Solarzellen bzw. Module entlang einer Verbindungskante zweier benachbarter Solarzellen bzw. Module sich überlappend angeordnet sind.

5. Fassaden- oder Dachelement nach einem der Ansprüche 1 bis 4, **dadurch gekennzeichnet, dass** die Mittel zum Zu- oder Abführen von Wärme ein viskoses bzw. flüssiges Wärmetransportmedium ist, geführt in einer Leitungsanordnung, welche mit der wärmeleitenden Schicht (5) bzw. den Wärmeleitlamellen wärmeleitend verbunden ist.

6. Fassaden- oder Dachelement nach einem der Ansprüche 1 bis 5, **dadurch gekennzeichnet, dass** die wärmeleitende Schicht (5) gleichzeitig Trägerplatte ist für die Solarzellen bzw. Module, um sowohl die Solarzellen bzw. Module am Element zu befestigen.

7. Dach- oder Fassadenkonstruktion aufweisend mehrere Dach- oder Fassadenelemente nach einem der Ansprüche 1 bis 6.

## Claims

1. Facade or roof element comprising several photovoltaic solar cells or modules, respectively, a heat conducting layer (5) being connected to the solar cells (31, 32, 33) or modules, respectively, as well as at least a thermal insulation (3), which is arranged at the surface of the heat conducting layer (5), the surface being opposite to the solar cells or modules, the heat conducting layer (5) being formed by several segments and receiving several solar cells or modules, respectively, such that one or several gradations (7) are provided in the heat conducting layer (5) or the segments of the heat conducting layer (5), that the overlapping of the solar cells or modules is provided in the area of the gradations of the heat conduction layer (5) or the segments, and that means (21) to supply or divert of heat to and from the heat conducting layer (5) are arranged in or at the heat conducting layers (5) .

2. Facade or roof element according to claim 1, **characterized in that** the thermal insulation (3) comprises grooves or slots (9) and/or interspaces are provided between heat conducting layer (5) and the thermal insulation (3) for the purpose of drain, dehumidify and/or ventilate of the elements.

3. Facade or roof element according to one of the claims 1 to 2, **characterized in that** the solar cell or the module, respectively, are detachably connected to the heat conducting layer (5).

4. Facade or roof element according to one of the claims 1 to 3, **characterized in that** at least a part of the solar cells or modules, respectively, are overlappingly arranged along a connecting edge of two neighbouring solar cells or modules, respectively.

5. Facade or roof element according to one of the claims 1 to 4, **characterized in that** the means to supply or divert of heat is a viscose or fluidic heat transport medium that is guided by a pipe arrangement which is thermally connected to the heat conducting layer (5) or the heat guiding lamellas, respectively.

6. Facade or roof element according to one of the claims 1 to 5, **characterized in that** the heat conducting layer (5) simultaneously is a carrying plate for the solar cells or modules, respectively, for fixing the solar cells or modules, respectively, to the element.

7. Roof or facade construction comprising several roof or facade elements according to one of the claims 1 to 6.

## Revendications

1. Elément de façade ou de toit présentant plusieurs cellules solaires photovoltaïques ou modules, une couche thermoconductrice (5) étant reliée aux cellules solaires (31, 32, 33) ou modules, et au moins une isolation thermique (3) étant agencée sur la surface de la couche thermoconductrice (5) opposée aux cellules solaires ou modules, la couche thermoconductrice (5) étant formée par plusieurs segments et recevant plusieurs cellules solaires ou modules, **caractérisé en ce qu'**il est prévu dans la couche thermoconductrice (5) ou dans les segments de la couche thermoconductrice (5) un ou plusieurs paliers (7), **en ce qu'**il est prévu un chevauchement des cellules solaires ou modules dans la zone des paliers de la couche thermoconductrice (5) ou des segments pour garantir l'écoulement de l'eau de pluie, et **en ce qu'**il est agencé dans ou sur la ou les couches thermoconductrices (5) des moyens (21) pour diriger la chaleur dans la couche thermoconductrice (5) ou l'en évacuer.

2. Elément de façade ou de toit selon la revendication 1, **caractérisé en ce que** l'isolation thermique (3) présente des stries ou des rainures (9) et **en ce qu'**il est prévu entre la couche thermoconductrice (5) et l'isolation thermique (3) des espaces pour assécher, déshumidifier et/ou ventiler l'élément.

3. Elément de façade ou de toit selon l'une des revendications 1 à 2, **caractérisé en ce que** la cellule solaire ou le module est raccordé(e) de façon amovible à la couche thermoconductrice (5).

4. Elément de façade ou de toit selon l'une des revendications 1 à 3, **caractérisé en ce qu'**au moins une partie des cellules solaires ou modules sont agencés en se chevauchant le long d'un bord de jonction de deux cellules solaires ou modules adjacents.

5. Elément de façade ou de toit selon l'une des revendications 1 à 4, **caractérisé en ce que** le moyen pour diriger ou évacuer la chaleur est un agent caloporteur visqueux ou liquide, guidé dans un ensemble de conduites qui est raccordé de façon thermoconductrice avec la couche thermoconductrice (5) ou les lamelles thermoconductrices.

6. Elément de façade ou de toit selon l'une des revendications 1 à 5, **caractérisé en ce que** la couche thermoconductrice (5) est en même temps une plaque de support pour les cellules solaires ou modules pour fixer les cellules solaires et les modules à l'élément.

7. Construction de toit ou de façade présentant plusieurs éléments de toit ou de façade selon l'une des revendications 1 à 6.
